# EUROPÄISCHE PATENTANMELDUNG

(11) **EP 2 998 749 A1**
(43) Veröffentlichungstag der Anmeldung: **23.03.2016**
(21) Anmeldenummer: 15181407.6
(22) Anmeldetag: 18.08.2015
(51) Int. Cl.: G01R 15/18, G01R 19/20

(54) **STROMMESSVORRICHTUNG UND VERFAHREN ZUM ERFASSEN EINES STROMS**

(30) Priorität: 19.08.2014 DE 102014216404
(71) Anmelder: Energy Depot Deutschland GmbH, 78462 Konstanz (DE)
(72) Erfinder: BURKHARDT, Roland, 8280 Kreuzlingen (CH); DOBRENKO, Alexey, 78467 Konstanz (DE); FAKLER, Peter, 78462 Konstanz (DE)
(74) Vertreter: Isarpatent

(57) **Zusammenfassung**

Die vorliegende Erfindung offenbart eine Strommessvorrichtung zum Erfassen eines durch eine Stromleitung fließenden zu erfassenden Stroms mit einer Magnetschleife zur Aufnahme der Stromleitung, mit einer Erregervorrichtung, welche dazu ausgebildet ist, die Magnetschleife mittels eines periodischen Signals zu magnetisieren, welches derart ausgebildet ist, dass ein durch das periodische Signal in der Erregervorrichtung hervorgerufener Erregerstrom immer zwischen zwei Sättigungsgrenzen der Magnetschleife pendelt, mit einer Ermittlungsvorrichtung, welche ausgebildet ist, eine durch den zu erfassenden Strom hervorgerufene Magnetisierung der Magnetschleife mittels einer in einer an der Magnetschleife angebrachten Sekundärspule induzierten Messspannung zu erfassen und das Integral der Messspannung zu bilden und aus der integrierten Messspannung die Stromstärke des zu erfassenden Stroms abzuleiten, wobei das zeitliche Intervall der Integration so ausgebildet ist, dass der Erregerstrom und das periodische Signal während der Integration immer das gleiche Vorzeichen aufweisen. Ferner offenbart die vorliegende Erfindung ein entsprechendes Verfahren zum Erfassen eines Stroms.

## Beschreibung

Die vorliegende Erfindung bezieht sich auf eine Strommessvorrichtung und ein entsprechendes Verfahren zum Erfassen eines Stroms.

### Stand der Technik

Es existiert heute eine Vielzahl von Stromsensoren zur Erfassung kleiner Ströme. Solche Stromsensoren können z.B. Differenzströme in Schutzeinrichtungen (Fehlerstromschalter, RCD) erfassen.

Solche Stromsensoren werden auch in Umrichtern, die trafolos an das Verbundnetz angeschlossen sind, eingesetzt. Oft werden in solchen Anwendungen spezielle Fehlerstromschalter gefordert, die DC- und AC-Differenzströme erfassen können und bei AC-Anteilen zwischen Wirk- und Blindstrom unterscheiden können.

Für solche Strommessungen sind die üblichen Fehlerstromschalter allerdings nicht geeignet, weshalb auf andere Weise eine geeignete Fehlerstromerfassung realisiert werden muss.

Einfache Stromsensoren mit einem Luftspalt, in dem das induzierte Magnetfeld mittels einer Mess-Sonde (z.B. Hall-Sonde) gemessen wird, sind für solche Anwendungen schlecht geeignet. Durch den Luftspalt treten externe Magnetfelder in den Sensor ein und verfälschen die Messung. Des Weiteren müssen Stromsensoren für Differenzstrommessungen absolut symmetrisch aufgebaut sein, da sich sonst die Magnetfelder, die durch den hin- und rückfliesenden Strom erzeugt werden, im differenzstromfreien Fall nicht ideal kompensieren und dadurch ein Messfehler entsteht. Ein solcher symmetrischer Aufbau ist aber nur sehr schwierig zu erreichen und es bleibt immer eine Unsymmetrie bestehen.

Um diese Probleme zu umgehen, werden z.B. passive Differenzstromsensoren eingesetzt, die auf dem Trafoprinzip basieren, weshalb hier kein Luftspalt benötigt wird. Ein geschlossener Magnetkreis schützt den Sensor gegen den Eintritt externer Magnetfelder, weshalb eine hervorragende Genauigkeit bei kleinen zu messenden Magnetfeldern erreicht werden kann. Aus diesem Grund haben solche Stromsensoren die oben beschriebenen Nachteile nicht, allerdings ist prinzipbedingt keine Erfassung eines DC-Anteils möglich.

Zur Erfassung des DC-Anteils muss auch ein konstantes Magnetfeld im Sensorkern erfasst werden können. Hierfür dienen verschiedene Methoden, die aktiv das Messsystem steuern um die Größe des Magnetfeldes im Kern zu ermitteln.

Bekannt sind Stromsensoren, in denen die Messspule als frequenzbestimmendes Bauelement in einer Multivibratorschaltung integriert ist. Beim Magnetisieren der Messspule durch einen zu erfassenden Strom wird das Tastverhältnis der Trägerspannung so beeinflusst, dass es dem zeitlichen Verlauf des zu erfassenden Stroms entspricht.

Dieses Verfahren hat aber den Nachteil, dass die Empfindlichkeit des Stromsensors gering ist und von der Zeitkonstante der Hilfswicklung abhängig ist. Ferner muss bei Sensoren mit diesem Messprinzip die Zeit gemessen werden und in eine elektrische Größe gewandelt werden, um ein analoges oder digitales Messsignal zu erhalten.

Solche Stromsensoren weisen eine hohe Komplexität und damit einen hohen Preis auf.

### Offenbarung der Erfindung

Es ist daher eine Aufgabe der vorliegenden Erfindung einen vereinfachten Stromsensor bereitzustellen.

Demgemäß offenbart die vorliegende Erfindung eine Strommessvorrichtung mit den Merkmalen des Patentanspruchs 1 und ein Verfahren mit den Merkmalen des Patentanspruchs 11.

### Demgemäß ist vorgesehen:

Eine Strommessvorrichtung zum Erfassen eines durch eine Stromleitung fließenden zu erfassenden Stroms mit einer Magnetschleife zur Aufnahme der Stromleitung, mit einer Erregervorrichtung, welche dazu ausgebildet ist, die Magnetschleife mittels eines periodischen Signals zu magnetisieren, welches derart ausgebildet ist, dass ein durch das periodische Signal in der Erregervorrichtung hervorgerufener Erregerstrom immer zwischen zwei Sättigungsgrenzen der Magnetschleife pendelt, mit einer Ermittlungsvorrichtung, welche ausgebildet ist, eine durch den zu erfassenden Strom hervorgerufene Magnetisierung der Magnetschleife mittels einer in einer an der Magnetschleife angebrachten Sekundärspule induzierten Messspannung zu erfassen und das Integral der Messspannung zu bilden und aus der integrierten Messspannung die Stromstärke des zu erfassenden Stroms abzuleiten, wobei das zeitliche Intervall der Integration so ausgebildet ist, dass der Erregerstrom und das periodische Signal während der Integration immer das gleiche Vorzeichen aufweisen.

### Ferner ist vorgesehen:

Ein Verfahren zum Erfassen eines Stroms, insbesondere mittels einer erfindungsgemäßen Strommessvorrichtung, aufweisend Durchführen einer Stromleitung durch eine Magnetschleife, Bestromen der Stromleitung mit dem zu erfassenden Strom, Magnetisieren der Magnetschleife, in welcher die Stromleitung angeordnet ist, welche den zu erfassenden Strom führt, mittels eines periodischen oder aperiodischen Signals durch eine Erregervorrichtung, Ableiten einer Stromstärke des zu erfassenden Stroms aus dem Integral einer durch eine Sekundärspule erfassten Messspannung über ein vorgegebenes Zeitfenster.

### Vorteile der Erfindung

Die der vorliegenden Erfindung zu Grunde liegende Idee besteht darin, eine durch den zu messenden Strom hervorgerufene Verschiebung der Sättigungsgrenzen der Magnetschleife auszuwerten und daraus die Stromstärke des zu erfassenden Stroms zu ermitteln.

Ob sich der Kern in der Sättigung befindet, kann man mit einer Sekundärspule feststellen. Mit zunehmender Sättigung des Kerns sinkt die induzierte Spannung in der Sekundärspule. Integriert man die in der Sekundärspule induzierte Spannung in dem Zeitraum vom Nulldurchgang des Erregerstromes bis zum Sättigungspunkt über beide Magnetisierungsrichtungen, erhält man eine Spannungszeitfläche, die dem zu erfassenden Strom proportional ist. Die vorliegende Erfindung ermöglicht es also, den zu messenden Strom direkt in eine elektrische Größe zur Weiterverarbeitung umzuwandeln.

Vorteilhafte Ausführungsformen und Weiterbildungen ergeben sich aus den Unteransprüchen sowie aus der Beschreibung unter Bezugnahme auf die Figuren.

In einer Ausführungsform weist die Erregervorrichtung einen Erregergenerator auf, welcher ausgebildet ist, das periodische Signal als eine periodische oder aperiodische Erregerspannung zu generieren. Ferner weist die Erregervorrichtung eine Erregerspule auf, welche dazu ausgebildet ist, die Magnetschleife mittels der Erregerspannung zu magnetisieren. Der Erregergenerator kann als eine Wechselstromquelle ausgebildet sein, welche eine rechteckige, sinusförmige oder eine beliebig anders ausgebildete periodische Spannung erzeugt. In alternativen Ausführungsformen kann der Erregergenerator ein periodisches Signal aber auch über eine Anordnung von Schaltelementen, wie zum Beispiel eine Voll- oder Halbbrücke, erzeugen. Ein solcher Aufbau ermöglicht es, den Verlauf der periodischen Spannung, zum Beispiel in Abhängigkeit von dem Einsatzgebiet der Strommessvorrichtung, zu beeinflussen. Wird eine einzelne Erregerspule verwendet, um die Magnetschleife mittels des periodischen Signals zu magnetisieren, dann ergibt sich vorteilhafterweise ein besonders einfacher Aufbau der Strommessvorrichtung. Wird dagegen statt der einzelnen Erregerspule eine Transformatorvorrichtung verwendet, um
die Magnetschleife zu magnetisieren, dann ist eine flexible Anpassung der Erregervorrichtung an die jeweilige Anwendung möglich.

In einer Ausführungsform weist die Ermittlungsvorrichtung eine Integrationsvorrichtung auf, welche ausgebildet ist, für jede Periode des Erregerstroms in einem ersten Zeitraum die Messspannung der Sekundärspule zu integrieren, in welchem der Erregerstrom und die Erregerspannung einen positiven Betrag aufweisen, und in einem zweiten Zeitraum die Messspannung der Sekundärspule zu integrieren, in welchem der Erregerstrom und die Erregerspannung einen negativen Betrag aufweisen. Ferner ist die Integrationsvorrichtung ausgebildet, als Maß für den zu erfassenden Strom das Integral der Messspannung der Sekundärspule in beiden Zeiträumen auszugeben. Die Integrationsvorrichtung kann z.B. als einfacher analoger RC-Integrator oder dergleichen aufgebaut sein. Dadurch wird es möglich, auf sehr einfache Art die Stromstärke des zu erfassenden Stroms zu berechnen.

In einer Ausführungsform ist eine Kompensationsvorrichtung vorgesehen, welche dazu ausgebildet ist, die Magnetschleife durch eine Kompensationsspule zusätzlich mit einem Kompensationsstrom in Abhängigkeit von der ermittelten Stromstärke in Gegenrichtung zu einer durch den zu erfassenden Strom hervorgerufenen Magnetisierung zu magnetisieren. Die Kompensationsvorrichtung ist derart ausgestaltet, dass sie die Magnetisierung, welche der zu erfassende Strom in der Magnetschleife hervorruft, kompensiert. Dadurch wird verhindert, dass das Material der Magnetschleife in die Sättigung gerät. Für die Strommessvorrichtung bedeutet dies eine Linearisierung des Messbereichs der Strommessvorrichtung. Ein zu erfassender Strom, welcher das Material der Magnetschleife ohne die Kompensationsvorrichtung bis zur Sättigung magnetisiert hätte, kann dennoch erfasst werden. In einer solchen Ausführungsform der Strommessvorrichtung ist ein Kompensationsstrom, welcher in der Kompensationsvorrichtung fließt proportional zu dem zu erfassenden Strom und kann daher als Maß für die Stromstärke des zu erfassenden Stroms dienen. Dadurch ist gewissermaßen eine Messbereichserweiterung möglich. Ein zweiter positiver Effekt bei Verwendung der Kompensationsvorrichtung besteht darin, dass die Magnetschleife sich immer im selben Arbeitspunkt befindet und so die Messung unabhängig von der Nichtlinearität der Magnetschleife macht.

In einer Ausführungsform weist die Kompensationsvorrichtung einen Kompensationsgenerator auf, welcher dazu ausgebildet ist, den Kompensationsstrom in Abhängigkeit von der erfassten Stromstärke zu erzeugen. Wird ein Kompensationsgenerator, zum Beispiel in Form eines Operationsverstärkers, eingesetzt, um die Kompensationsspannung zu erzeugen, kann dieser das Signal der Ermittlungsvorrichtung direkt verarbeiten. Dadurch ist ein besonders einfacher Aufbau der Strommessvorrichtung ermöglicht.

In alternativen Ausgestaltungsformen kann der Kompensationsgenerator einen digitalen Schaltkreis aufweisen, welcher die Kompensationsspannung in Abhängigkeit von digitalen Schaltsignalen oder Steuerbefehlen erzeugt. Dies ermöglicht die Integration zumindest eines Teils des Kompensationsgenerators in eine programmgesteuerte Vorrichtung, wie etwa einen Mikroprozessor. Ist in der Anwendung mit der Strommessvorrichtung eine programmgesteuerte Vorrichtung vorhanden, welche über genügend freie Rechenressourcen verfügt, um die Funktion des Kompensationsgenerators auszuführen, dann kann eine sehr kompakte Strommessvorrichtung bereitgestellt werden. Insbesondere müssen keine zusätzlichen Komponenten für den Kompensationsgenerator eingesetzt werden. Ist für den Kompensationsgenerator ein eigener digitaler Schaltkreis vorgesehen, dann kann ein sehr flexibel steuerbarer Kompensationsgenerator verwendet werden.

In einer Ausführungsform weist die Kompensationsvorrichtung einen Stromsensor auf, welcher dazu ausgebildet ist, den in der Kompensationsspule fließenden Kompensationsstrom zu erfassen. Der Kompensationsstrom kann z.B. mit Hilfe eines Shuntwiderstands gemessen werden. Dies ermöglicht eine sehr einfache Erfassung des Kompensationsstroms.

In einer Ausführungsform ist eine Kalibriervorrichtung vorgesehen, welche dazu ausgebildet ist, die Magnetschleife mit einem Kalibrierstrom zu magnetisieren und eine kalibrierte Stromstärke des durch die Strommessvorrichtung zu messenden Stroms zu erzeugen.

In einer Ausführungsform weist die Kalibriervorrichtung ferner eine Stromquelle, welche in Abhängigkeit eines Steuersignals den Kalibrierstrom mit einer definierten Stromstärke erzeugt, und eine Steuervorrichtung auf, welche periodisch in zeitlich vorbestimmten Abständen eine erste Stromstärke des Kompensationsstromes speichert und danach das Steuersignal zum Einschalten der Stromquelle erzeugt, und eine Kalibrierspule, welche mit der Stromquelle gekoppelt ist und dazu ausgebildet ist, die Magnetschleife zusätzlich in Abhängigkeit des definierten Kalibrierstroms zu magnetisieren, wobei die Steuervorrichtung derart ausgebildet ist, eine zweite Stromstärke des Kompensationsstromes dann zu speichern, wenn die Magnetschleife mittels des definierten Kalibrierstroms magnetisiert ist, und wobei die Steuervorrichtung derart ausgebildet ist, aus der Differenz der ersten gespeicherten Stromstärke und der zweiten gespeicherten Stromstärke die kalibrierte Stromstärke zu bestimmen. Durch eine solche Ausgestaltung der Kalibriervorrichtung kann zu beliebigen Zeitpunkten eine Kalibrierung der Strommessvorrichtung durchgeführt werden und dadurch eine erhöhte Genauigkeit des Messergebnisses erreicht werden. Die Steuervorrichtung erzeugt in einer solchen Anordnung ein Signal, welches die kalibrierte Stärke des zu messenden Stroms aufweist. Dieses Signal kann als analoges Signal oder als digitales Signal ausgebildet sein.

In einer Ausführungsform ist die Erregerspule oder die Sekundärspule oder die Kompensationsspule ausgebildet, die Magnetschleife mit dem Kalibrierstrom zu magnetisieren. Dadurch wird es möglich, auf die Kalibrierspule zu verzichten und die Strommessvorrichtung zu vereinfachen.

In einer Ausführungsform ist die Integrationsvorrichtung als analoge Schaltung ausgebildet. Dadurch kann eine sehr einfache Integrationsvorrichtung bereitgestellt werden.

In einer Ausführungsform ist eine integrierte Schaltung, insbesondere eine programmgesteuerte Einrichtung, vorgesehen, welche die Integrationsvorrichtung aufweist. Dadurch kann eine sehr flexible und anpassungsfähige Integrationsvorrichtung bereitgestellt werden.

In einer Ausführungsform ist die Magnetschleife als eine luftspaltlose Magnetschleife ausgebildet. Dies erhöht die Unempfindlichkeit der Strommessvorrichtung gegen äußere Störungen.

In einer Ausführungsform ist die Erregerspule als eine einzelne oder eine doppelte Spule ausgebildet.

In einer Ausführungsform sind in der Magnetschleife zwei oder mehreren stromführenden Leitungen angeordnet. Dadurch wird es möglich Differenzströme zu messen.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung. Insbesondere wird dabei der Fachmann auch Einzelaspekte als Verbesserungen oder Ergänzungen zu der jeweiligen Grundform der vorliegenden Erfindung hinzufügen.

### Kurze Beschreibung der Zeichnungen

Die vorliegende Erfindung wird nachfolgend anhand der in den schematischen Figuren der Zeichnungen angegebenen Ausführungsbeispiele näher erläutert. Es zeigen dabei:
- Fig. 1: ein Blockschaltbild einer Ausführungsform einer erfindungsgemäßen Strommessvorrichtung;
- Fig. 2: ein Ablaufdiagramm einer Ausführungsform eines erfindungsgemäßen Verfahrens;
- Fig. 3: Diagramme für unterschiedliche Stärken des zu messenden Stroms;
- Fig. 4: ein Blockschaltbild einer weiteren Ausführungsform einer erfindungsgemäßen Strommessvorrichtung;
- Fig. 5: ein Blockschaltbild einer weiteren Ausführungsform einer erfindungsgemäßen Strommessvorrichtung;
- Fig. 6: ein Blockschaltbild einer weiteren Ausführungsform einer erfindungsgemäßen Strommessvorrichtung; und
- Fig. 7: ein Blockschaltbild einer weiteren Ausführungsform einer erfindungsgemäßen Strommessvorrichtung.

In allen Figuren sind gleiche bzw. funktionsgleiche Elemente und Vorrichtungen - sofern nichts Anderes angegeben ist - mit denselben Bezugszeichen versehen worden.

### Ausführungsformen der Erfindung

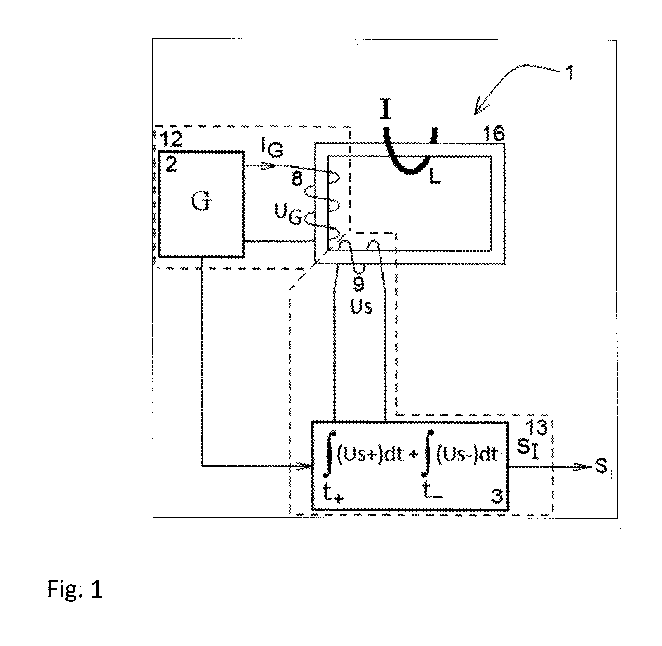

Fig. 1 zeigt ein Blockschaltbild einer Ausführungsform einer erfindungsgemäßen Strommessvorrichtung 1.

In Fig. 1 weist die Strommessvorrichtung 1 eine Erregervorrichtung 12 auf, die einen Erregergenerator 2 aufweist, welcher als periodisches Signal eine periodische Spannung (U_{G}) erzeugt, so dass der vom Erregergenerator (2) erzeugte Erregerstrom (I_{G}) immer zwischen zwei Sättigungsgrenzen einer Magnetschleife 16 pendelt.

Die Erregervorrichtung 12 weist ferner eine Erregerspule 8 auf, welche um die Magnetschleife 16 gewickelt ist und welche dazu ausgebildet ist, die Magnetschleife 16 mittels der periodischen Spannung U_{G} zu magnetisieren. Durch die Magnetschleife 16 ist ferner ein Leiter L geführt, durch welchen der zu erfassende Strom I fließt.

Der Erregergenerator 2 kann als eine Wechselstromquelle 2 ausgebildet sein, welche eine rechteckige, sinusförmige oder eine beliebig anders ausgebildete periodische oder auch aperiodische Spannung U_{G} erzeugt. Für eine einzelne Messung ist eine Periode ausreichend.

Falls eine kontinuierliche Strommessung nicht gefordert ist, kann zwischen den einzelnen Messungen eine Pause eingeführt werden, was z.B. zur Reduzierung des Energieeigenverbrauchs der Strommessvorrichtung 1 genutzt werden kann.

In einer Ausführungsform kann der Erregergenerator 2 ein periodisches Signal U_{G} über eine Anordnung von Schaltelementen, wie zum Beispiel eine Voll- oder Halbbrücke, erzeugen. Ein solcher Aufbau ermöglicht es, den Verlauf der periodischen Spannung U_{G} , zum Beispiel in Abhängigkeit von dem Einsatzgebiet der Strommessvorrichtung 1, zu beeinflussen.

Wird eine einzelne Erregerspule 8 verwendet, um die Magnetschleife 16 mittels des periodischen Signals U_{G} zu magnetisieren, dann ergibt sich vorteilhafterweise ein besonders einfacher Aufbau der Strommessvorrichtung 1.

Ferner ist eine Ermittlungsvorrichtung 13 vorgesehen, welche eine Integrationsvorrichtung 3 aufweist, welche für jede Periode des Erregerstroms I_{G} in dem ersten Zeitraum t+ die Messspannung Us der Sekundärspule 9 integriert, in welchem Erregerstrom I_{G} und Erregerspannung U_{G} einen positiven Betrag aufweisen. Die Integrationsvorrichtung 3 integriert ferner für jede Periode des Erregerstroms in dem zweiten Zeitraum t- die Messspannung Uₛ der Sekundärspule 9, in welchem der Erregerstrom I_{G} und die Erregerspannung U_{G} einen negativen Betrag aufweisen.

Die Ermittlungsvorrichtung 13 bildet als Maß für den zu erfassenden Strom ein Integral der Messspannung Uₛ der Sekundärspule 9 von beiden Zeiträumen.

Eine solche Ausgestaltung der Ermittlungsvorrichtung 13 ermöglicht einen schaltungstechnisch sehr einfachen Aufbau durch Verwendung von einfachen analogen Komponenten.

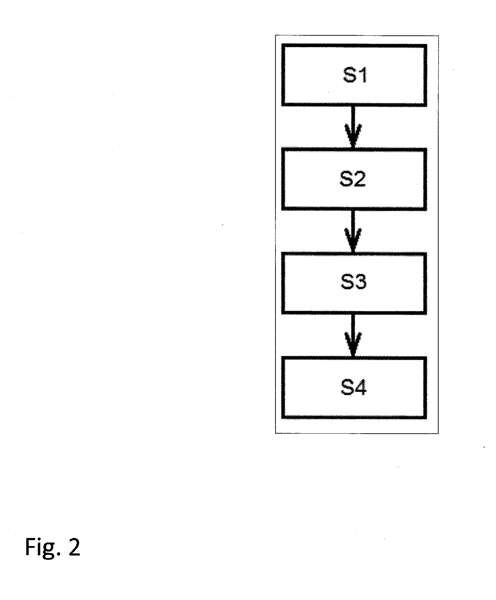

Fig. 2 zeigt ein Ablaufdiagramm einer Ausführungsform eines erfindungsgemäßen Verfahrens.

Das Verfahren sieht das Durchführen S1 einer Stromleitung L durch eine Magnetschleife 16, das Bestromen S2 der Stromleitung L mit dem zu erfassenden Strom I, das Magnetisieren S3 der Magnetschleife 16, in welcher die Stromleitung L angeordnet ist, welche den zu erfassenden Strom I führt, mittels eines periodischen oder aperiodischen Signals U_{G} durch eine Erregervorrichtung 2, und das Ableiten S4 einer Stromstärke S_{I} des zu erfassenden Stroms I aus dem Integral einer durch eine Sekundärspule 9 erfassten Messspannung Uₛ über ein vorgegebenes Zeitfenster vor.

In einer Ausführungsform ist das periodischen oder aperiodischen Signals U_{G} als eine Erregerspannung U_{G} ausgebildet, welche in der Erregervorrichtung 2 einen Erregerstrom I_{G} erzeugt und welche über die Magnetschleife 16 in der Sekundärspule 9 eine Messspannung U_{S} induziert. Ferner weist das Ableiten S4 der Stromstärke S_{I} auf: Integrieren der Messspannung U_{S} über einen ersten Zeitraum t+, in welchem der Erregerstrom I_{G} und die Erregerspannung U_{G} ein positives Vorzeichen aufweisen, Integrieren der Messspannung U_{S} über einen zweiten Zeitraum t-, in welchem der Erregerstrom I_{G} und die Erregerspannung U_{G} ein negatives Vorzeichen aufweisen; und Bestimmen der Stromstärke S_{I} aus dem Integrationsergebnis.

In einer Ausführungsform weist das Verfahren ferner das Erzeugen eines Kompensationsstromes Iₖ durch einen Kompensationsgenerator 4 in Abhängigkeit von der ermittelten Stromstärke S_{I}, und das Magnetisieren der Magnetschleife 16 durch eine Kompensationsspule 11 mit Hilfe des Kompensationsstromes Ik auf.

In einer Ausführungsform weist das Verfahren ferner das periodische Speichern einer ersten Stromstärke S_{IK} des Kompensationsstromes Ik, wobei die Magnetschleife 16 dabei nicht zusätzlich mittels eines definierten Teststromes I_{Test} magnetisiert ist, das Einschalten einer Stromquelle 7 welche den definierten Teststrom I_{Test} erzeugt, das Magnetisieren der Magnetschleife 16 durch eine Kalibrierspule 10 mittels des definierten Teststromes Iₜₑₛₜ, das Speichern einer zweiten Stromstärke S_{IK} des Kompensationsstromes Ik, welcher in der Kompensationsspule 11 fließt, wobei die Magnetschleife 16 dabei zusätzlich mittels des definierten Teststromes I_{Test} magnetisiert ist, und das Bestimmen einer kalibrierten Stromstärke S_{IKal} mittels der Differenz der ersten Stromstärke und der zweiten Stromstärke des Kompensationsstromes Ik durch die Steuervorrichtung 6 auf.

In einer besonders bevorzugten Ausführungsform weist das erfindungsgemäße Verfahren zumindest zwei Betriebsmodi auf. In einem ersten Betriebsmodus lassen sich mittels der Strommessvorrichtung 1 Gleichströme DC erfassen und in einem zweiten Betriebsmodus lassen sich mittels der Strommessvorrichtung 1 Wechselströme AC erfassen. Die erfindungsgemäße Strommessvorrichtung 1 ist somit zur Erfassung von AC- und DC-Strömen ausgelegt und damit universell einsetzbar. Vorzugsweise ist ein dritter Betriebsmodus vorgesehen, bei dem mittels der Strommessvorrichtung 1 gleichzeitig Gleich- und Wechselströme erfasst werden.

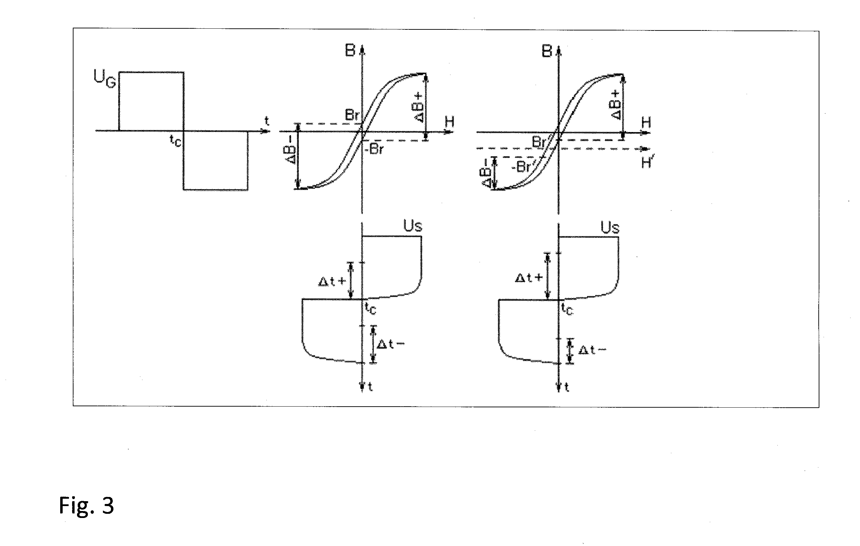

Fig. 3 zeigt Diagramme für unterschiedliche Stärken des zu messenden Stroms.

In Fig. 3 ist links ein Diagramm dargestellt, welches eine Periode der Erregerspannung U_{G} über die Zeit darstellt. Für die erste Hälfte der Periode weist die Erregerspannung U_{G} einen vorgegebenen positiven Spannungswert auf und für die zweite Hälfte der Periode weist die Erregerspannung U_{G} einen vorgegebenen negativen Spannungswert auf.

Neben dem linken Diagramm in der Mitte ist ein B-H Diagramm dargestellt, welches den Verlauf der magnetischen Feldstärke und der magnetischen Flussdichte B in der Magnetschleife 16 bei nicht fließendem Strom I zeigt. Es ist zu sehen, dass sich die für Magnetkerne übliche Hysteresekurve ergibt, die achsensymmetrisch ist. Unter diesem Diagramm ist ein Diagramm gezeigt, welches darstellt, wie sich die Messspannung U_{S} verhält. Es ist zu erkennen, dass die Fläche unter der Kurve für die Messspannung U_{S} in dem ersten Zeitraum t+ und in dem zweiten Zeitraum t- sowohl für die erste Hälfte als auch die zweite Hälfte der Periode identische ist.

In Fig. 3 ist rechts ein B-H Diagramm dargestellt, welches den Verlauf der magnetischen Feldstärke H und der magnetischen Flussdichte B in der Magnetschleife 16 bei fließendem Strom I zeigt. Es ist zu sehen, dass nun die Hysteresekurve nicht mehr achsensymmetrisch ist. Unter diesem Diagramm ist ebenfalls ein Diagramm gezeigt, welches darstellt, wie sich die Messspannung U_{S} verhält. Es ist zu erkennen, dass die Fläche unter der Kurve für die Messspannung U_{S} in dem ersten Zeitraum t+ deutlich größer ist, als in dem zweiten Zeitraum t-.

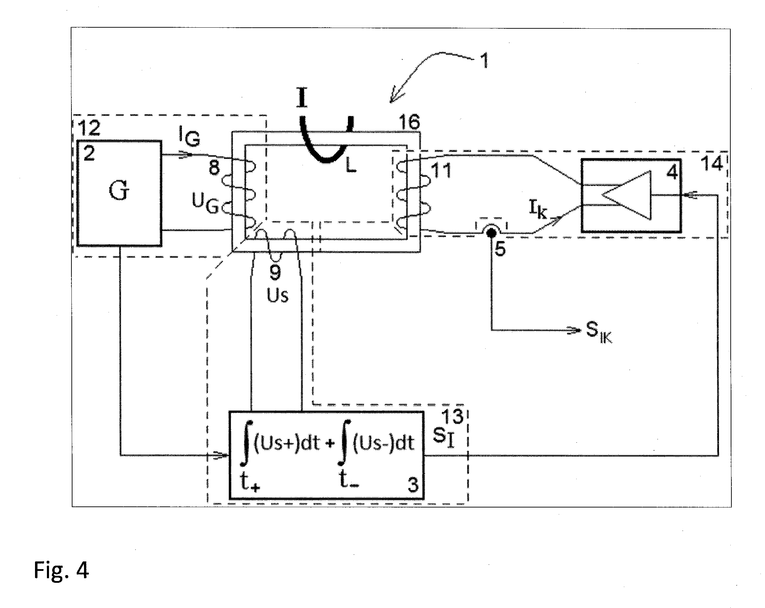

Fig. 4 zeigt ein Blockschaltbild einer weiteren Ausführungsform einer erfindungsgemäßen Strommessvorrichtung 1.

Die Strommessvorrichtung 1 der Fig. 4 basiert auf der Strommessvorrichtung 1 der Fig. 1.

Ferner weist die Strommessvorrichtung 1 der Fig. 4 eine Kompensationsvorrichtung 14 auf, welche dazu ausgebildet ist, die Magnetschleife 16 mit einer Kompensationsspule 11 zusätzlich in Abhängigkeit von der ermittelten Stromstärke S_{I} zu magnetisieren.

Ohne eine Kompensationsvorrichtung 14 gerät das ferromagnetische Kernmaterial der Magnetschleife 16 ab einer bestimmten Stärke des zu erfassenden Stroms I in die Sättigung. Ein weiteres Ansteigen des Stroms I führt dann zu keiner weiteren Erhöhung der magnetischen Flussdichte in der Magnetschleife 16, sodass ab dieser Stromschwelle der zu erfassende Strom I ohne eine Kompensationsvorrichtung 14 nicht erfasst werden kann.

Die Kompensationsvorrichtung 14 ist derart ausgestaltet, dass sie die Magnetisierung, welche der zu erfassende Strom I in der Magnetschleife 16 hervorrufen würde, kompensiert. Dadurch wird verhindert, dass das Material der Magnetschleife 16 in die Sättigung gerät. Für die Strommessvorrichtung 1 bedeutet dies eine Linearisierung des Messbereichs. Ein zu erfassender Strom I, welcher das Material der Magnetschleife 16 ohne die Kompensationsvorrichtung 14 bis zur Sättigung magnetisiert hätte, kann dennoch erfasst werden. In einer solchen Ausführungsform der Strommessvorrichtung 1 ist ein Kompensationsstrom Ik, welcher in der Kompensationsvorrichtung 14 fließt proportional zu dem zu erfassenden Strom I und kann daher als Maß für die Stromstärke des zu erfassenden Stroms I dienen. Dadurch ist gewissermaßen eine Messbereichserweiterung möglich.

Der Kompensationsstrom Ik kann mit Hilfe eines Stromsensors 5, zum Beispiel eines Shuntwiderstands, gemessen werden. Ein zweiter positiver Effekt bei Verwendung der Kompensationsvorrichtung 14 besteht darin, dass die Magnetschleife 16 sich immer im selben Arbeitspunkt befindet und so die Messung unabhängig von der Nichtlinearität der Magnetschleife 16 macht.

Die Kompensationsvorrichtung 14 weist einen Kompensationsgenerator 4 auf, welcher dazu ausgebildet ist, den Kompensationsstrom Ik in Abhängigkeit von der erfassten Stromstärke S_{I} zu erzeugen.

Die Kompensationsvorrichtung 14 weist dazu eine Kompensationsspule 11 auf, welche dazu ausgebildet ist, die Magnetschleife 16 zusätzlich mittels dem erzeugten Kompensationsstrom Ik in Gegenrichtung zu magnetisieren. Wird ein Kompensationsgenerator 4, zum Beispiel in Form einer gesteuerten Stromquelle mit analogen Schaltkreis, eingesetzt, um den Kompensationsstrom Ik zu erzeugen, kann dieser das Signal der Ermittlungsvorrichtung 13 direkt verarbeiten. Dadurch wird ein besonders einfacher Aufbau der Strommessvorrichtung 1 ermöglicht.

In alternativen Ausgestaltungsformen kann der Kompensationsgenerator 4 einen digitalen Schaltkreis aufweisen, welcher der Kompensationsstrom Ik in Abhängigkeit von digitalen Schaltsignalen oder Steuerbefehlen erzeugt. Dies ermöglicht die Integration zumindest eines Teils des Kompensationsgenerators 4 in eine programmgesteuerte Vorrichtung, wie etwa einem Mikroprozessor. Ist in der Anwendung mit der Strommessvorrichtung 1 eine programmgesteuerte Vorrichtung vorhanden, welche über genügend freie Rechenressourcen verfügt, um die Funktion des Kompensationsgenerators 4 auszuführen, dann kann eine sehr kompakte Strommessvorrichtung 1 bereitgestellt werden. Insbesondere müssen keine zusätzlichen Komponenten für den Kompensationsgenerator 4 eingesetzt werden. Ist für den Kompensationsgenerator 4 ein eigener digitaler Schaltkreis vorgesehen, dann kann ein sehr flexibel steuerbarer Kompensationsgenerator 4 verwendet werden.

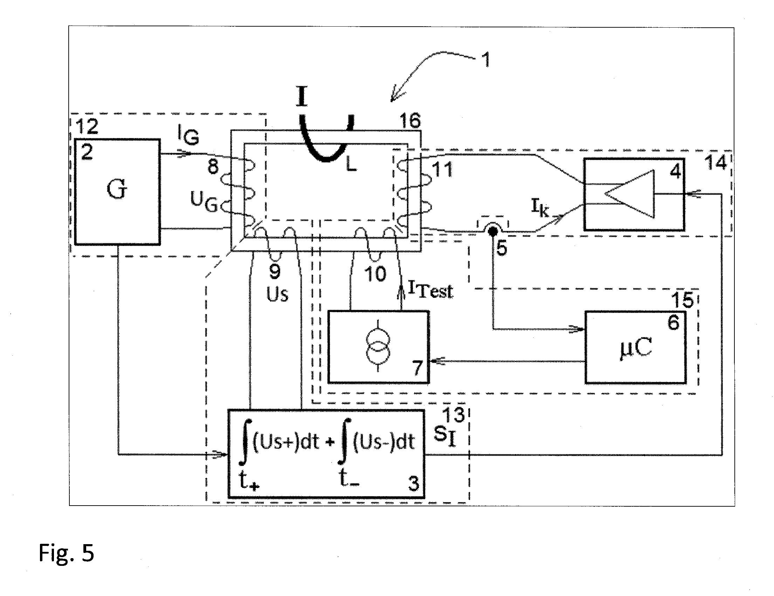

Fig. 5 zeigt ein Blockschaltbild einer weiteren Ausführungsform einer erfindungsgemäßen Strommessvorrichtung 1.

Die Strommessvorrichtung 1 der Fig. 5 basiert auf der Strommessvorrichtung 1 der Fig. 4.

Ferner weist die Strommessvorrichtung 1 der Fig. 5 eine Kalibriervorrichtung 15 auf, welche ebenfalls dazu ausgebildet ist, die Magnetschleife 16 zu magnetisieren.

Die Kalibriervorrichtung 15 ist dazu ausgebildet, in der Kompensationsspule 11 eine kalibrierte Stromstärke des durch die Strommessvorrichtung 1 zu erfassenden Stroms I zu erzeugen.

Die Kalibriervorrichtung 15 weist dazu eine Steuervorrichtung 6 auf, welche periodisch in zeitlich vorbestimmten Abständen eine erste Stromstärke des Kompensationsstromes Ik speichert und danach ein Steuersignal zum Einschalten erzeugt. Die Kalibriervorrichtung 15 weist ferner eine Stromquelle 7 auf, welche in Abhängigkeit des Steuersignals einen definierten Strom I_{Test} erzeugt.

Ferner ist eine Kalibrierspule 10 vorgesehen, welche dazu ausgebildet ist, die Magnetschleife 16 zusätzlich in Abhängigkeit des definierten Stroms I_{Test} zu magnetisieren. Die Steuervorrichtung 6 ist derart ausgebildet, eine zweite Stromstärke des Kompensationsstromes Ik dann zu speichern, wenn die Magnetschleife 16 mittels des definierten Stroms I_{Test} magnetisiert ist.

Die Steuervorrichtung 6 ist derart ausgebildet, aus der Differenz der ersten gespeicherten Stromstärke und der zweiten gespeicherten Stromstärke eine kalibrierte Stromstärke zu bestimmen.

Durch eine solche Ausgestaltung der Kalibriervorrichtung 15 kann zu beliebigen Zeitpunkten eine Kalibrierung der Strommessvorrichtung durchgeführt werden und dadurch eine erhöhte Genauigkeit des Messergebnisses erreicht werden. Die Steuervorrichtung 6 erzeugt in einer solchen Anordnung ein Signal, welches die kalibrierte Stärke des zu messenden Stroms aufweist. Dieses Signal kann als analoges Signal oder als digitales Signal ausgebildet sein.

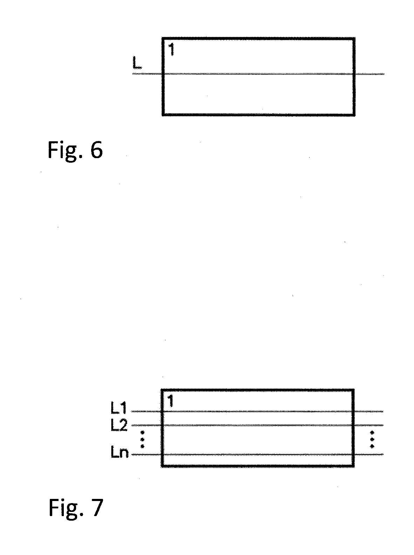

Fig. 6 zeigt ein Blockschaltbild einer weiteren Ausführungsform einer erfindungsgemäßen Strommessvorrichtung 1.

In Fig. 6 ist durch die Strommessvorrichtung 1 lediglich ein einzelner Leiter L geführt. Die Strommessvorrichtung 1 kann also den durch den Leiter L fließenden Strom I erfassen.

Fig. 7 zeigt ein Blockschaltbild einer weiteren Ausführungsform einer erfindungsgemäßen Strommessvorrichtung 1.

In Fig. 7 sind durch die Strommessvorrichtung 1 eine Vielzahl von Leitern L1 - Ln geführt. Die Strommessvorrichtung 1 kann also den Differenzstrom der durch die Vielzahl von Leitern L1 - Ln fließenden Ströme erfassen.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### Bezugszeichenliste

- 1: Strommessvorrichtung
- 2: Erregergenerator
- 3: Integrationsvorrichtung
- 4: Kompensationsgenerator
- 5: Stromsensor
- 6: Steuervorrichtung
- 7: Stromquelle
- 8: Erregerspule
- 9: Messspule
- 10: Kalibrierspule
- 11: Kompensationsspule
- 12: Erregervorrichtung
- 13: Ermittlungsvorrichtung
- 14: Kompensationsvorrichtung
- 15: Kalibriervorrichtung
- 16: Magnetschleife

- L: Stromleitung
- I: Strom
- U_{G}: Erregerspannung
- I_{G}: Erregerstrom
- t+, t-: Zeiträume
- S_{I}: Stromstärke
- Iₖ: Kompensationsstrom
- I_{Test}: definierter Strom
- S1-S4: Verfahrensschritte

## Patentansprüche

1. Strommessvorrichtung (1) zum Erfassen eines durch eine Stromleitung (L) fließenden zu erfassenden Stroms (I),
mit einer Magnetschleife (16) zur Aufnahme der Stromleitung (L);
mit einer Erregervorrichtung (12), welche dazu ausgebildet ist, die Magnetschleife (16) mittels eines periodischen Signals (U_{G}) zu magnetisieren, welches derart ausgebildet ist, dass ein durch das periodische Signal (U_{G}) in der Erregervorrichtung (12) hervorgerufener Erregerstrom (I_{G}) immer zwischen zwei Sättigungsgrenzen der Magnetschleife (16) pendelt;
mit einer Ermittlungsvorrichtung (13), welche dazu ausgebildet ist, eine durch den zu erfassenden Strom (I) hervorgerufene Magnetisierung der Magnetschleife (16) mittels einer in einer an der Magnetschleife (16) angebrachten Sekundärspule (9) induzierten Messspannung (Us) zu erfassen und das Integral der Messspannung (Us) zu bilden und aus der integrierten Messspannung (U_{S}) die Stromstärke (S_{I}) des zu erfassenden Stroms (I) abzuleiten;
wobei das zeitliche Intervall der Integration so ausgebildet ist, dass der Erregerstrom (I_{G}) und das periodische Signal (U_{G}) während der Integration immer das gleiche Vorzeichen aufweisen.

2. Strommessvorrichtung (1) nach Anspruch 1,
**dadurch gekennzeichnet, dass**
die Erregervorrichtung (12) einen Erregergenerator (2) aufweist, welcher dazu ausgebildet ist, das periodische Signal (U_{G}) als eine periodische oder aperiodische Erregerspannung (U_{G}) zu generieren, und eine Erregerspule (8) aufweist, welche dazu ausgebildet ist, die Magnetschleife (16) mittels der Erregerspannung (U_{G}) zu magnetisieren.

3. Strommessvorrichtung (1) nach einem der vorherigen Ansprüche,
**dadurch gekennzeichnet, dass**
die Ermittlungsvorrichtung (13) eine Integrationsvorrichtung (3) aufweist, welche dazu ausgebildet ist, für jede Periode des Erregerstroms (I_{G}) in einem ersten Zeitraum (t+) die Messspannung (Us) der Sekundärspule (9) zu integrieren, in welchem der Erregerstrom (I_{G}) und die Erregerspannung (U_{G}) einen positiven Betrag aufweisen, und in einem zweiten Zeitraum (t-) die Messspannung (U_{S}) der Sekundärspule (9) zu integrieren, in welchem der Erregerstrom (I_{G}) und die Erregerspannung (U_{G}) einen negativen Betrag aufweisen;
wobei die Integrationsvorrichtung (3) dazu ausgebildet ist, als Maß für den zu erfassenden Strom (I) das Integral der Messspannung (Us) der Sekundärspule (9) in beiden Zeiträumen auszugeben.

4. Strommessvorrichtung (1) nach einem der vorherigen Ansprüche,
**dadurch gekennzeichnet, dass**
eine Kompensationsvorrichtung (14) vorgesehen ist, welche dazu ausgebildet ist, die Magnetschleife (16) durch eine Kompensationsspule (11) zusätzlich mit einem Kompensationsstrom (Ik) in Abhängigkeit von der ermittelten Stromstärke (S_{I}) in Gegenrichtung zu einer durch den zu erfassenden Strom (I) hervorgerufenen Magnetisierung zu magnetisieren.

5. Strommessvorrichtung (1) nach Anspruch 4,
**dadurch gekennzeichnet, dass**
die Kompensationsvorrichtung (14) einen Kompensationsgenerator (4) aufweist, welcher dazu ausgebildet ist, den Kompensationsstrom (Ik) in Abhängigkeit von der Stromstärke (S_{I}) zu erzeugen.

6. Strommessvorrichtung (1) nach einem der vorherigen Ansprüche 4 und 5,
**dadurch gekennzeichnet, dass**
die Kompensationsvorrichtung (14) einen Stromsensor (5) aufweist, welcher dazu ausgebildet ist, den in der Kompensationsspule (11) fließenden Kompensationsstrom (Ik) zu erfassen.

7. Strommessvorrichtung (1) nach einem der vorherigen Ansprüche,
**dadurch gekennzeichnet, dass**
eine Kalibriervorrichtung (15) vorgesehen ist, welche dazu ausgebildet ist, die Magnetschleife (16) mit einem Kalibrierstrom (I_{Test}) zu magnetisieren und eine kalibrierte Stromstärke des durch die Strommessvorrichtung (1) zu messenden Stroms (I) zu erzeugen.

8. Strommessvorrichtung nach einem der Ansprüche 4 bis 6 und nach Anspruch 7, **dadurch gekennzeichnet, dass**
die Kalibriervorrichtung (13) ferner aufweist:
eine Stromquelle (7), welche in Abhängigkeit eines Steuersignals den Kalibrierstrom (I_{Test}) mit einer definierten Stromstärke erzeugt;
eine Steuervorrichtung (6), welche periodisch in zeitlich vorbestimmten Abständen eine erste Stromstärke des Kompensationsstromes (Ik) speichert und danach das Steuersignal zum Einschalten der Stromquelle (7) erzeugt;
eine Kalibrierspule (10), welche mit der Stromquelle (7) gekoppelt ist und dazu ausgebildet ist, die Magnetschleife (16) zusätzlich in Abhängigkeit des definierten Kalibrierstroms (I_{Test}) zu magnetisieren;
wobei die Steuervorrichtung (6) derart ausgebildet ist, eine zweite Stromstärke des Kompensationsstromes (Ik) dann zu speichern, wenn die Magnetschleife (1) mittels des definierten Kalibrierstroms (I_{Test}) magnetisiert ist, und wobei die Steuervorrichtung (6) derart ausgebildet ist, aus der Differenz der ersten gespeicherten Stromstärke und der zweiten gespeicherten Stromstärke die kalibrierte Stromstärke zu bestimmen.

9. Strommessvorrichtung nach einem der vorherigen Ansprüche,
**dadurch gekennzeichnet,**
**dass** die Erregerspule (8) oder die Sekundärspule (9) oder die Kompensationsspule (11) ausgebildet ist, die Magnetschleife mit dem Kalibrierstrom (Iₜₑₛₜ) zu magnetisieren; und/oder
**dass** die Integrationsvorrichtung (3) als analoge Schaltung ausgebildet ist; und/oder
**dass** eine integrierte Schaltung, insbesondere eine programmgesteuerte Einrichtung, vorgesehen ist, welche die Integrationsvorrichtung (3) aufweist; und/oder
**dass** die Magnetschleife (16) als eine luftspaltlose Magnetschleife (16) ausgebildet ist; und/oder
**dass** die Erregerspule (8) als eine einzelne oder eine doppelte Spule ausgebildet ist.

10. Strommessvorrichtung (1) nach einem der vorherigen Ansprüche,
**dadurch gekennzeichnet, dass**
in der Magnetschleife (16) zwei oder mehreren stromführenden Leitungen angeordnet sind.

11. Verfahren zum Erfassen eines Stroms (I), insbesondere mittels einer
Strommessvorrichtung (1) nach einem der Ansprüche 1 bis 10, aufweisend:
Durchführen (S1) einer Stromleitung (L) durch eine Magnetschleife (16);
Bestromen (S2) der Stromleitung (L) mit dem zu erfassenden Strom (I);
Magnetisieren (S3) der Magnetschleife (16), in welcher die Stromleitung (L) angeordnet ist, welche den zu erfassenden Strom (I) führt, mittels eines periodischen oder aperiodischen Signals (U_{G}) durch eine Erregervorrichtung (2);
Ableiten (S4) einer Stromstärke (S_{I}) des zu erfassenden Stroms (I) aus dem Integral einer durch eine Sekundärspule (9) erfassten Messspannung (U_{S}) über ein vorgegebenes Zeitfenster.

12. Verfahren nach Anspruch 11,
**dadurch gekennzeichnet, dass**
das periodischen oder aperiodischen Signals (U_{G}) als eine Erregerspannung (U_{G}) ausgebildet ist, welche in der Erregervorrichtung (2) einen Erregerstrom (I_{G}) erzeugt und welche über die Magnetschleife (16) in der Sekundärspule (9) eine Messspannung (U_{S}) induziert; und
das Ableiten (S4) der Stromstärke (S_{I}) aufweist:
Integrieren der Messspannung (U_{S}) über einen ersten Zeitraum (t+), in welchem der Erregerstrom (I_{G}) und die Erregerspannung (U_{G}) ein positives Vorzeichen aufweisen;
Integrieren der Messspannung (U_{S}) über einen zweiten Zeitraum (t-), in welchem der Erregerstrom (I_{G}) und die Erregerspannung (U_{G}) ein negatives Vorzeichen aufweisen; und
Bestimmen der Stromstärke (S_{I}) aus dem Integrationsergebnis.

13. Verfahren nach einem der Ansprüche 11 oder 12, ferner aufweisend:
Erzeugen eines Kompensationsstromes (Ik) durch einen Kompensationsgenerator (4) in Abhängigkeit von der ermittelten Stromstärke (S_{I}); und
Magnetisieren der Magnetschleife (16) durch eine Kompensationsspule (11) mit Hilfe des Kompensationsstromes (Ik).

14. Verfahren nach Anspruch 13, ferner aufweisend:
periodisches Speichern einer ersten Stromstärke (S_{IK}) des Kompensationsstromes (Ik), wobei die Magnetschleife (16) dabei nicht zusätzlich mittels eines definierten Teststromes (I_{Test}) magnetisiert ist;
Einschalten einer Stromquelle (7) welche den definierten Teststrom (I_{Test}) erzeugt;
Magnetisieren der Magnetschleife (16) durch eine Kalibrierspule (10) mittels des definierten Teststromes (I_{Test});
Speichern einer zweiten Stromstärke (S_{IK}) des Kompensationsstromes (Ik), welcher in der Kompensationsspule (11) fließt, wobei die Magnetschleife (16) dabei zusätzlich mittels des definierten Teststromes (I_{Test}) magnetisiert ist;
Bestimmen einer kalibrierten Stromstärke (S_{I}Kal) mittels der Differenz der ersten Stromstärke und der zweiten Stromstärke des Kompensationsstromes (Ik) durch die Steuervorrichtung (6).

15. Verfahren nach einem der vorherigen Ansprüche 11 bis 14,
**gekennzeichnet durch** einen ersten Betriebsmodus, in dem mittels der Strommessvorrichtung Gleichströme erfasst werden; und/oder
**gekennzeichnet durch** einen zweiten Betriebsmodus, in dem mittels der Strommessvorrichtung Wechselströme erfasst werden; und/oder
**gekennzeichnet durch** einen dritten Betriebsmodus, bei dem mittels der Strommessvorrichtung gleichzeitig Gleich- und Wechselströme erfasst werden.
